# EUROPÄISCHE PATENTSCHRIFT

(11) **EP 0 976 183 B1**
(45) Veröffentlichungstag und Bekanntmachung des Hinweises auf die Patenterteilung: **19.06.2002**
(21) Anmeldenummer: 98906845.7
(22) Anmeldetag: 26.01.1998
(51) Int. Cl.: H01S 5/40, H01S 5/0625, G02B 6/12

(54) **WELLENLÄNGENABSTIMMBARES OPTOELEKTRONISCHES BAUELEMENT**
WAVELENGTH TUNABLE OPTOELECTRONIC COMPONENT
COMPOSANT OPTOELECTRONIQUE ACCORDABLE EN LONGUEUR D'ONDE

(30) Priorität: 01.03.1997 DE 19708385
(43) Veröffentlichungstag der Anmeldung: 02.02.2000
(73) Patentinhaber: Deutsche Telekom AG, 53113 Bonn (DE)
(72) Erfinder: HILLMER, Hartmut, D-64287 Darmstadt (DE); KLEPSER, Bernd, 98617 Meiningen (DE)
(86) Internationale Anmeldenummer: DE9800225
(87) Internationale Veröffentlichungsnummer: WO9838711

(56) Entgegenhaltungen:
- EP-A- 0 732 785
- DE-A- 4 432 410
- HILLMER H ET AL: "TAILORED DFB LASER PROPERTIES BY INDIVIDUALLY CHIRPED GRATINGS USING BENT WAVEGUIDES" IEEE JOURNAL OF SELECTED TOPICS IN QUANTUM ELECTRONICS, Bd. 1, Nr. 2, 1.Juni 1995, Seiten 356-362, XP000521097
- HILLMER H ET AL: "NOVEL TUNABLE SEMICONDUCTOR LASERS USING CONTINUOUSLY CHIRPED DISTRIBUTED FEEDBACK GRATINGS WITH ULTRAHIGH SPATIAL PRECISION" APPLIED PHYSICS LETTERS, Bd. 65, Nr. 17, 24.Oktober 1994, Seiten 2130-2132, XP000476494 in der Anmeldung erwähnt
- PATENT ABSTRACTS OF JAPAN vol. 018, no. 174 (E-1530), 24.März 1994 & JP 05 343789 A (HIKARI KEISOKU GIJUTSU KAIHATSU KK), 24.Dezember 1993,

## Beschreibung

Das erfindungsgemäße optoelektronische Bauelement bezieht sich unter anderem auf das Gebiet der wellenlängenabstimmbaren Laser und der Laserzeilen.

Auf dem Gebiet der Festfrequenz- bzw. Festwellenlängen-Laserzeilen gibt es zahlreiche Publikationen und Patente. Stellvertretend dafür seien genannt:
K. Sato et al. IEEE Phot. Technol. Lett. 3, 501 (1991).
C. E. Zah, et al. Electron. Lett. 27, 1041 (1991).

Desweiteren sind in der Wellenlänge abstimmbare Mehrsektions-Bauelemente bekannt. Als Beispiele dieser Thematik sind folgende Arbeiten angeführt:
S. Murata et al. Optical and Quantum Electronics 22, 1 (1990).
K. Dutta et al. Appl. Phys. Lett. 48, 1501 (1986).
M. Kuznetsov, J. Lightw. Technol. 12, 2100 (1994).
Y. Tohmori et al. IEEE J. Quantum Electron. 29, 1817 (1993).

Es sind Lösungen bekannt, die auf einem Halbleiterbauelement mit lateral nebeneinander liegenden Mehrsektions-DFB-Lasern basieren. Bei diesen Lösungen wird die Wellenlängenabstimmung über individuelle Strominjektion in die Sektionen eines jeden Lasers der Laser-Zeile erreicht. Ein Nachteil dieses Bauelements ist, daß der Bereich der Wellenlängenabstimmung sehr gering ist. Als Beispiele sind aufgeführt:
K. Sato et al. IEEE J. Quantum Electronics 29, 1805 (1993).
H. Yasaka et al. IEEE Phot. Technol. Lett. 1, 75 (1989).

Weitere Lösungen basieren auf einem Halbleiterbauelement mit lateral nebeneinander liegenden Mehrsektion-DBR-Lasern. Hier wurde die Wellenlängenabstimmung über inidviduelle Strominjektion in die Sektionen eines jeden Lasers der Laser-Zeile erreicht. Als Beispiel wird aufgeführt:
Y. Kato et al. Int. Conf. on InP and Related Compounds 1995, Technical Digest WA 1.4.

Eine weitere bekannte Lösung beruht auf einer Laserzeile, bei der jeder einzelne Laser mit einer dünnen Metallfilm-Widerstandsheizung thermisch abgestimmt werden kann. Eine solche Lösung wurde beispielsweise in folgender Veröffentlichung beschrieben:
Li, et al. IEEE Photon. Technol. Lett. 8, 22 (1996).
Lo et al. J. Lightwave Technology 11, 619 (1993).

Bekannt ist auch der Einsatz von gekippten Wellenleitern auf homogenen DFB-Gitterfeldern, welche im Wellenleiter eine effektive Gitterperiode definieren. Die effektive Gitterperiode korreliert mit der Gitterperiode des homogenen Gitters und dem Kippwinkel des Gitters ϕ.
Siehe
M.-A. Diforte, FR-A-2 417 866 (1978).
W. T. Tsang et al. IEEE Photon. Technol. Lett. %, 978 (1993).
W. T. Tsang, EP 0 641 053 A1.

Die Berechnung der Modenstruktur und der Schwellenstromdichte, d. h. die Festlegung der Krümmungsfunktionen der Wellenleiter geschieht mittels Modellrechnungen, welche z. B. auf der Theorie der gekoppelten Moden basieren. Siehe
K. Kogelnik and C. V. Shank, J. Appl. Phys. 43, 2327 (1972).

Gekrümmte Wellenleiter auf homogenen DFB-Gitterfeldern können zur Definition von Gittern mit axial variierter Gitterperiode genutzt werden.
Siehe
Shoji et al. DE 3643361 A1, (1987).
D. A. Ackerman, US 5,052,015 (1991).

3-Sektions-Laser mit DFB Gittern mit axial variierter Gitterperiode wurden beschrieben in
H. Ishii, EP 0 559 192 A2 (1993).
H. Hillmer et al. Appl. Phys. Lett. 65, 2130 (1994).

Aus DE-A-44 32 410 ist ein optoelektronisches Bauelement mit einem gekrümmten Wellenleiter bekannt. Die Wellenleiterkrümmung dient der Erzeugung einer Phasenverschiebung.

In Hillmer H. et al. " Tailored DFB Laser Properies by individually chirped Gratings using bent Waveguides" IEEE Journal of selected Topics in Quantum Electronics, Bd.1, Nr.2 1. Juni 1995, Seiten 356-362 wird ein optoelektronisches Bauelement mit einem einzigen gekrümmten Wellenleiter beschrieben. Die Sektionierung, die verschiedenen Steuerströme und die Wellenleiterkrümmung dienen der Wellenlängendurchstimmung.

Das Ziel der Erfindung ist ein optoelektronisches Bauelement, das auf verschiedenen Wellenlängenkanälen arbeitet, welche individuell in der Wellenlänge variiert werden können. Derartigen Bauelementen kommt eine Schlüsselfunktion für Wellenlängenmultiplexverfahren bei der Datenübertragung in Glasfasern zu. Derartig ausgebildete optoelektronische Bauelemente können beispielsweise als Laser-Zeilen, Laser-Verstärker-Zeilen und Filter-Zeilen ausgebildet sein.
Die technische Aufgabe besteht in der Entwicklung einer Struktur für ein optoelektronisches Bauelement mit den o.g. Eigenschaften.

Eine erfindungsgemäß ausgebildete optoelektronische Bauelementezeile bedient maximal n Kanäle, welche in ihrer charakteristischen Wellenlänge durch Steuerströme einzeln abstimmbar sind. Beispiele für diese Bauelementezeilen sind wellenlängenabstimmbare Laserzeilen, wellenlängenabstimmbare Verstärkerzeilen, wellenlängenabstimmbare Filterzeilen, wellenlängenabstimmbare Detektorzeilen und wellenlängenabstimmbare Konverterzeilen. Jeder einzelne Kanal korrespondiert zu einem individuell gekrümmten optischen Lichtwellenleiter. Für jeden dieser Lichtwellenleiter definiert eine individuelle Funktion yᵢ(x) den Verlauf des Maximums des geführten Lichtfeldes in der xy-Ebene, d. h. die individuellen Wellenleiterkrümmungen, wobei i ganzzahlig ist, im Bereich 1 ≤ i ≤ n. Die axiale Richtung i folgt dabei der Krümmung des Lichtwellenleiters der Ordnungszahl i, d. h., es handelt sich dabei in der xy-Ebene um eine gekrümmt verlaufende Koordinate. Im Fall einer Laserzeile besteht jeder Lichtwellenleiter aus der laseraktiven Zone 3 und den umgebenden Materialien, welche in der xz-Ebene höchstens um die Lichtwellenlänge vom Zentrum des Lichtfeldes entfernt sind. Oberhalb oder unterhalb der xy-Ebene befindet sich ein Rückkopplungsgitter 4, dessen Gitterstriche gegenüber einer Vorzugsrichtung um den Kippwinkel ϕ verkippt sind. Der Gitterbereich wird in x - Richtung durch zwei Grenzflächen bei x = 0 und bei x = L begrenzt, wobei diese zwei Grenzflächen senkrecht zur x -Achse stehen. Dabei liegt das Rückkopplungsgitter 4 in einem Bereich, in dem der Betrag der Intensität des im Lichtwellenleiter geführten Lichtfeldes größer als I₀(x)/100 ist, wobei I₀(x) die Intensität im Maximum des Lichtfeldes in der yz-Ebene an der Stelle x ist. Für die Länge des Gitterbereiches L in x -Richtung gilt dabei für die dadurch erreichte Rückkopplung 0.2 ≤ K · L ≤ 7, wobei K der Kopplungskoeffizient des Rückkopplungsgitters 4 ist. Das Rückkopplungsgitter 4 ist dabei DFB-artig (DFB = engl. distributed feedback), DBR-artig (DBR = engl. distributed bragg reflector) ausgebildet oder es besitzt eine Übergitterstruktur (engl. sampled grating). Im letztgenannten Fall existieren in Richtung der Lichtausbreitung zusätzlich eine bestimmte Anzahl gitterfreier Bereiche. Das Rückkoplungsgitter 4 kann z. B. rein reelle Indexkopplung bewirken, rein imaginäre Indexkopplung, oder komplexe Kopplung (reelle und imaginäre Kopplung). Die Querschnittsform des Rückkopplungsgitters 4 (in Ebenen, welche die xy-Ebene senkrecht schneiden) ist entweder dreieckförmig, rechteckförmig oder sinusartig. Ferner sind entsprechende Mischformen möglich, wie z. B. eine Rechteckform mit abgerundeten Ecken. Für ein homogenes Rückkopplungsgitter 4 oder einen homogenen Teilbereich eines Gitters ist Λ₀ die Gitterperiode. Die Wellenlängenabstimmung wird durch eine Multisektionierung jedes einzelnen Lichtwellenleiters erreicht, wobei jede einzelne Sektion mit einem eigenen Steuerstrom gepumpt wird. Typischerweise handelt es sich pro Lichtwellenleiter um 2 bis 3 Sektionen, d. h., die Emissionswellenlänge eines Kanals wird mit zwei bis drei verschiedenen Steuerströmen eingestellt. Dabei ist die Wellenlänge des Kanals i etwa im Wellenlängenbereich Δλᵢ abstimmbar. Ein Beispiel dafür ist eine DFB-Halbleiterlaserzeile, welche aus n Lichtwellenleitern auf n verschiedenen Wellenlängen λᵢ emittiert, wobei i von 1 bis n läuft. Anders ausgedrückt kann das optoelektronische Bauelement simultan auf n verschiedenen Frequenz-Kanälen arbeiten. Dabei wird das Wellenlängenintervall Δλᵢ des Wellenleiters der Ordnungszahl i durch die Verkippung des Rückkopplungsgitters (Kippwinkel ϕ), die Gitterperiode Λ₀ des Rückkopplungsgitters und die korrespondierende Krümmungsfunktion des Lichtwellenleiters yᵢ(x) in seiner absoluten Wellenlängenlage voreingestellt. Die Emissionswellenlänge λᵢ wird schließlich durch die zum Lichtwellenleiter der Ordnungszahl i korrespondierenden Steuerströme fein abgestimmt. Dies gilt in analoger Weise für die restlichen Lichtwellenleiter der Bauelementezeile. Dabei sind sowohl die absoluten Wellenlängen der n Kanäle präzise einstellbar, wie auch die Wellenlängen-Abstände der einzelnen Kanäle i zueinander. Damit können für WDM-Anwendungen z. B. Bauelementezeilen mit äquidistanten Frequenz- oder Wellenlängenabständen realisiert werden.

Der Winkel α_{li,i} beschreibt den Winkel zwischen dem Lichtwellenleiter der Ordnungszahl i und der Normalen auf die Bauelementefacette an der Stelle x = 0, (linkes Ende des Gitterbereiches). Der Winkel α_{re,i} beschreibt den Winkel zwischen dem Lichtwellenleiter der Ordnungszahl i und der Normalen auf die Bauelementefacette an der Stelle x = L, (rechtes Ende des Gitterbereiches). Die Breite der Lichtwellenleiter kann verschieden sein, was sich auf den effektiven Brechungsindex N_{eff,i} auswirkt. Die in den Figuren dargestellten linken und rechten Gittergrenzen (Grenzflächen) stehen für kristallographisch oder bauelementegeometrisch ausgezeichnete Richtungen. Es kann sich bei den Grenzflächen um gespaltene, geätzte oder lithographische Gittergrenzen, gespaltene oder geätzte Bauelementegrenzen, gespaltene Halbleiterwafer-Grenzen oder geätzte Grenzen auf dem Halbleiterwafer handeln. Im Falle, daß das Bauelement nicht an den Grenzflächen endet, können die Lichtwellenleiter außerhalb des Gitterbereiches weiterlaufen. Im gitterfreien Bereich können Verzweigungen, Combiner, Schalter, Taper usw. liegen. In diesem Fall stellt der in den Figuren betrachtete Bereich einen Ausschnitt aus einer integrierten optoelektronischen Schaltung dar.

Zur Verdeutlichung sind in den Abbildungen die Bauelemente-Ausdehnungen, die Winkel, die Wellenleiterbreiten, die Wellenleiterkrümmungen und die Korrugationsperioden nicht maßstabgerecht dargestellt. Typischerweise ist die laterale Wellenlängenbreite wesentlich größer als die Gitterperiode im Rückkopplungsgitter.

Das erfindungsgemäß ausgebildete optoelektronische Bauelement wird anhand von einigen Ausführungsbeispielen näher erläutert.

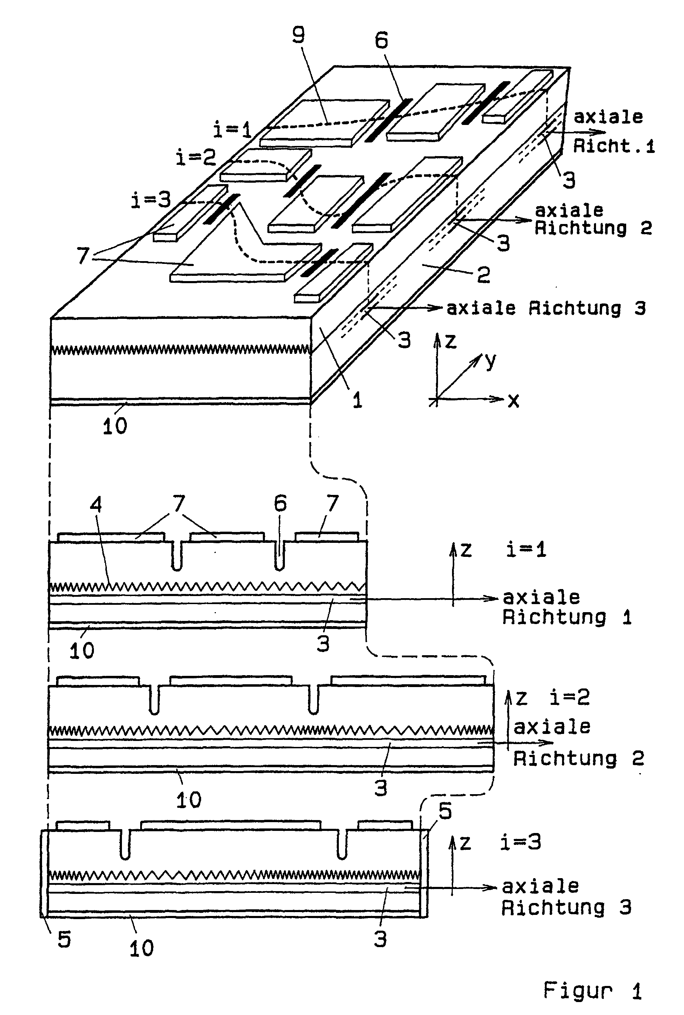

**Figur 1** zeigt die Darstellung einer Bauelementezeile mit n = 3 verschieden gekrümmten Lichtwellenleitern (i = 1, 2, 3) im oberen Bildteil. Die Kontaktierung jedes einzelnen Lichtwellenleiters ist zweimal unterbrochen, so daß drei 3-Sektions-Bauelemente existieren. An der in der perspektivischen Darstellung vorn liegenden Fläche ist ein Querschnitt durch ein Rückkopplungsgitter 4 vom DFB-Typ sichtbar. Dieses Rückkopplungsgitter 4 erstreckt sich in der xy-Ebene über die gesamte Fläche der Bauelementezeile.

Die gestrichelten Linien 9 geben die Projektionen der Wellenleiterzentren auf die Bauelementeoberfläche (parallel zur xy-Ebene) wieder. Der Verlauf des Zentrums des Wellenleiters der Ordnungszahl i gibt dabei die Wellenleiterkrümmung yᵢ(x) wieder. In diesem Sinne geben die gekrümmten Linien 9 die Projektionen der axialen Richtungen i auf die Bauelementeoberfläche wieder. Ferner geben sie in guter Näherung den Verlauf des Intensitätsmaximums des geführten Lichtfeldes wieder.

Im unteren Bildteil sind drei gekrümmte Schnitte entlang den Linien 9 durch die Bauelementezeile dargestellt, wobei jeweils ein Rückkopplungsgitter von DFB-Typ sichtbar ist, welches jeweils eine axial verschieden variierte Gitterperiode aufweist. Die z-Richtung ist senkrecht auf der xy-Ebene. Die axiale Richtung i verläuft in der xy-Ebene und folgt der Wellenleiterkrümmung des Lichtwellenleiters der Ordnungszahl i. Der Querschnitt in der gekrümmten Ebene zeigt: eine Volumenhalbleiterschicht 1 vom Leitfähigkeitstyp I , eine Volumenhalbleiterschicht 2 vom Leitfähigkeitstyp II , eine aktive Schicht 3, ein Rückkopplungsgitter 4, die Facettenvergütung 5, die Trennungsgräben bzw. die Kontakt-Trennungen 6, die Metallisierungsfelder (engl. contact pads) 7 der einzelnen Sektionen auf der Seite des Leitfähigkeitstyps I und die Metallisierung 10 auf der Seite des Leitfähigkeitstyps II. Durch die verschiedenen Krümmungsfunktionen weisen die drei Bauelemente längs der axialen Richtungen eine unterschiedliche gitterbehaftete Lichtwellenleiterlänge auf. In diesem Beispiel ist der Kippwinkel ϕ des Rückkopplungsgitters gegenüber einer Vorzugsrichtung sehr gering (ϕ = 0,5°). Das Rückkopplungsgitter 4 besitzt in diesem Anwendungsbeispiel einen dreieckförmigen Querschnitt.

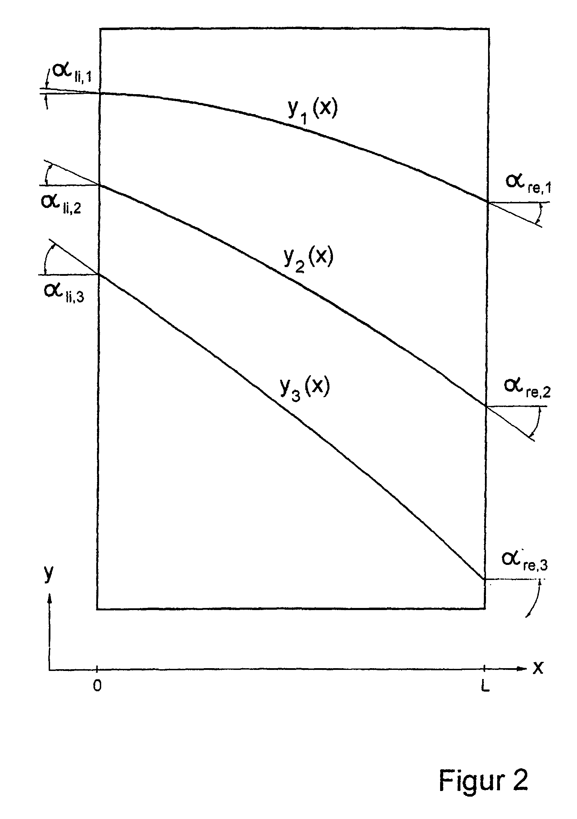

Figur 2 zeigt die Darstellung der Krümmungsfunktionen von 3 Lichtwellenleitern einer weiteren Bauelementezeile in der xy-Ebene. Im Rahmen der vorliegenden erfindungsgemäßen Lösung sind die Winkel α, wie sie in Figur 2 dargestellt sind, bezüglich ihres Vorzeichens positiv.

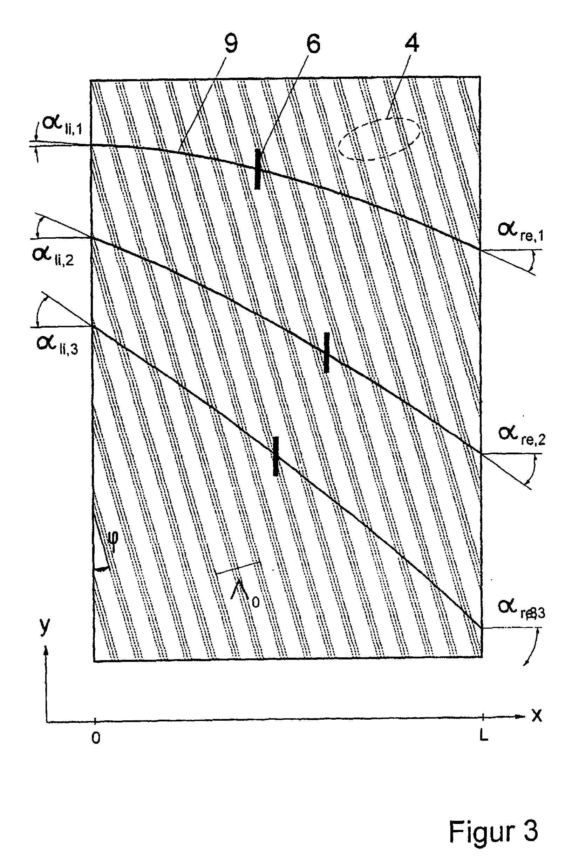

Figur 3 zeigt die simultane Darstellung einer weiteren xy-Ebene (Gitterebene), der in Figur 2 gezeigten Bauelementezeile. Das Rückkopplungsgitter 4 ist gegenüber einer Vorzugsrichtung um den Kippwinkel ϕ verkippt. Von jedem Lichtwellenleiter ist die Projektion des Wellenleiterzentrums in die xy-Ebene in Form der gekrümmten Linie 9 dargestellt. Jeder Wellenleiter ist in diesem Ausführungsbeispiel durch je einen Trennungsgraben 6 in zwei Sektionen unterteilt. Diese Trennungen sind in der vorliegenden Aufsicht durch schwarze Balken angedeutet und in Figur 1 unten in den drei Querschnitten als Trennungsgräben 6 zu sehen. Durch die dargestellten Trennungen besteht die Bauelementezeile in diesem Beispiel aus drei 2-Sektions-Bauelementen.

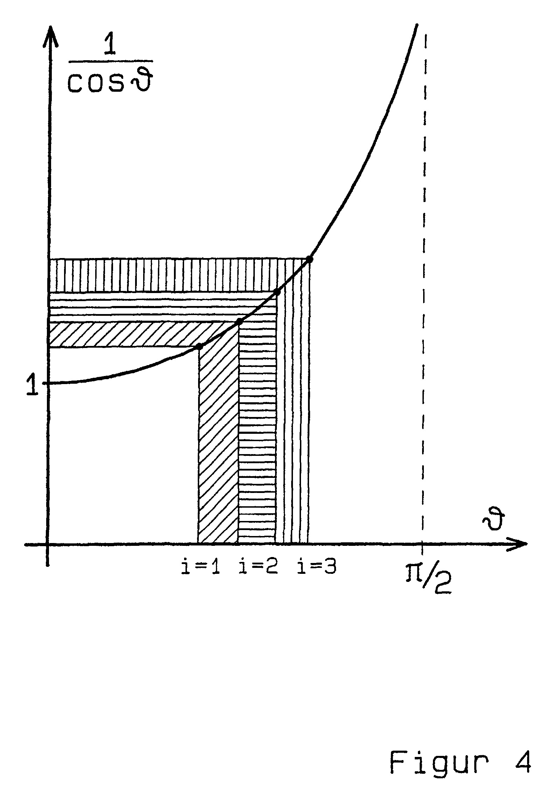

Durch die Wellenleiterkrümmung ändert sich in axialer Richtung der lokale Kippwinkel des Lichtwellenleiters ϑ gegenüber dem Rückkopplungsgitter 4. Dadurch verändert sich die effektive Gitterperiode, welche für das im Lichtwellenleiter geführte Lichtfeld vorliegt, gegenüber der Gitterperiode Λₒ im Rückkopplungsgitter um den Faktor 1/cosϑ. Das ist in Figur 4 verdeutlicht. Der lokale Kippwinkel ϑ des Lichtwellenleiters variiert somit entlang der axialen Richtung. Für die in den Figuren 2 und 3 dargestelle Bauelementezeile ist der Winkelbereich, den die einzelnen Wellenleiter durchlaufen, auf der ϑ-Achse dargestellt. Die Ordinate zeigt, daß die Variation der Gitterperiode bei größeren lokalen Kippwinkeln des Lichtwellenleiters ϑ effizienter ist, d. h. größere Gitterperiodenänderungen erreicht werden können.

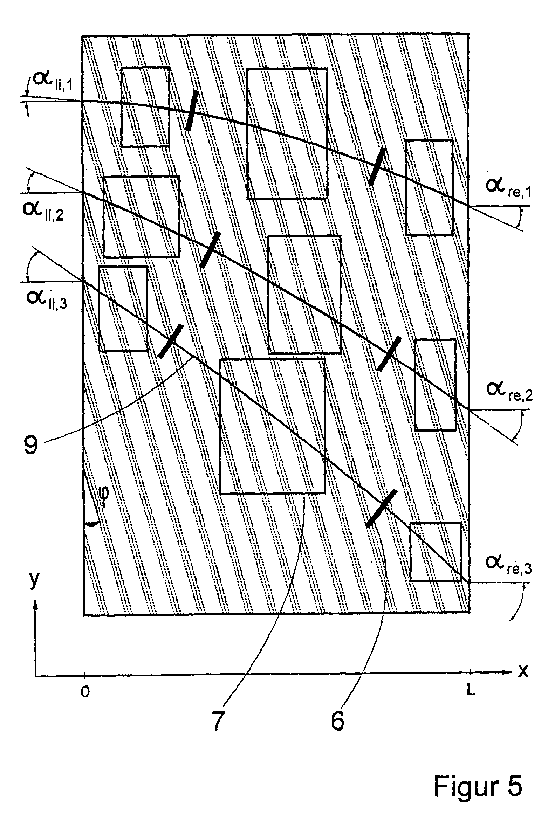

Figur 5 zeigt die Darstellung einer anderen Bauelementezeile, welche auf den in Figur 2 gezeigten Krümmungsfunktionen basiert, bei der jedoch jedem Wellenleiter zwei Trennungsgräben 6 zugeordnet sind. Dadurch entstehen bei dieser Bauelementezeile drei 3-Sektions-Bauelemente. Jede einzelne Sektion besitzt ein eigenes Metallisierungsfeld 7, welches in der englischsprachigen Literatur als "contact pad" oder "bond pad" bezeichnet wird. Jede Sektion kann dadurch durch einen individuellen Injektionsstrom angesteuert werden.

Figur 6 zeigt die Darstellung einer Bauelementezeile, welche vier Lichtwellenleiter enthält, denen jeweils eine Unterteilung zugeordnet ist. Dadurch entstehen bei dieser Bauelementezeile vier 2-Sektions-Baulemente.

Figur 7 zeigt die Darstellung einer Bauelementezeile, welche drei Lichtwellenleiter enthält, denen jeweils zwei Unterteilungen zugeordnet sind. Dadurch entstehen bei dieser Bauelementezeile drei 3-Sektions-Bauelemente.

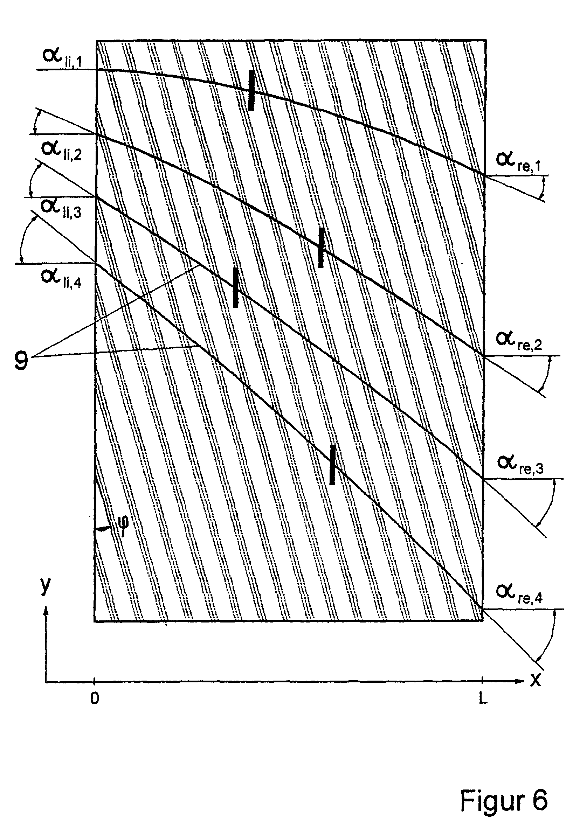

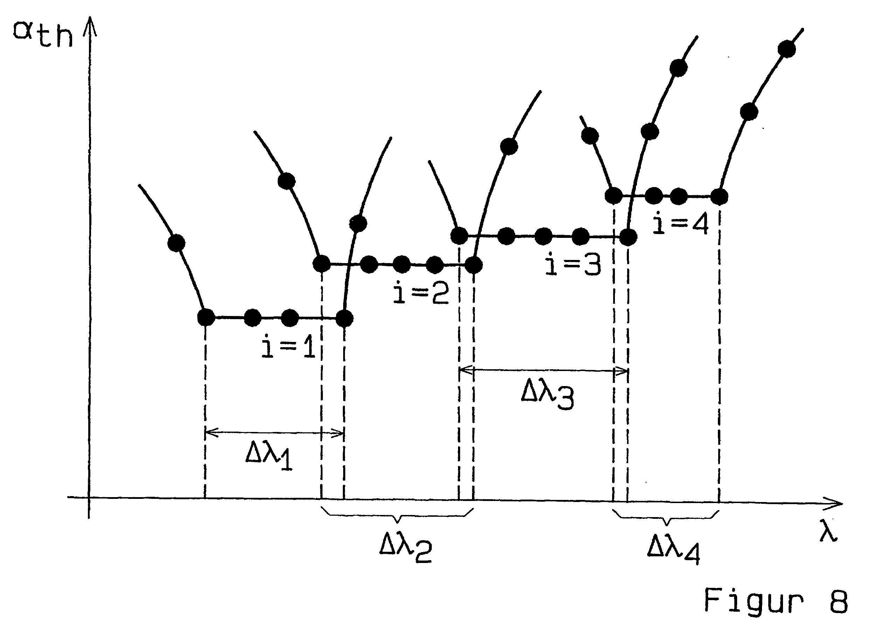

Durch eine geeignete Wahl der Krümmungsfunktionen der Lichtwellenleiters lassen sich mehrere spektral benachbarte Moden erzeugen, welche nahezu identische Schwellenverstärkungen α_{th,jᵢ,i} aufweisen, wobei jᵢ ganzzahlig im Bereich 1 ≤ jᵢ ≤ mᵢ ist. Die mᵢ spektral benachbarten Moden des Lichtwellenleiters der Ordnungszahl i erstrecken sich dabei über den Wellenlängenbereich Δλᵢ. Wählt man kürzere Gitterbereiche der Länge L und stärkere Krümmungen, so findet man spektral weiter ausgedehnte Wellenlängenbereiche Δλᵢ, in denen spektral benachbarte Moden mit ähnlicher Schwellenverstärkung existieren. Für eine Bauelementezeile ist in Fig. 8 durch vier speziell gekrümmte Wellenleiter eine derartige Situation realisiert. Die Wellenlängenbereiche Δλ₁, Δλ₂, Δλ₃ und Δλ₄ sind in ihren absoluten spektralen Lagen mit Hilfe der geometrischen Parameter der Krümmungsfunktionen so positioniert worden, daß sich deren Bereichsgrenzen spektral nur geringfügig überschneiden. Dabei sind ferner die Krümmungsfunktionen durch δ²y/δx² < 0 gekennzeichnet. Mit steigendem x liegt ein abfallendes Verhalten aller Krümmungsfunktionen yᵢ(x) der Bauelementezeile vor.(siehe z. B. Figur 6) sowie
α_{li,1} < α_{re,1}; α_{re,1} ∼ α_{li,2}; α_{li,2} < α_{re,2};
α_{re,2} ∼ α_{li,3}; α_{li,3} < α_{re,3} und α_{re,3} ∼ α_{li,4}.

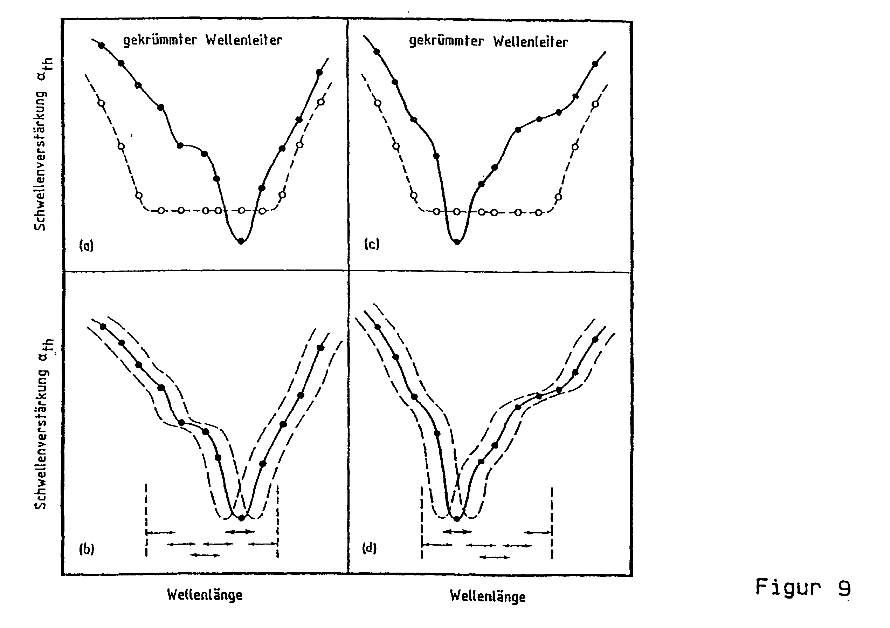

Das Prinzip der Wellenlängen-Durchstimmung wird schematisch an Hand von Figur 9 für eines der Mehrsektionsbauelemente einer Zeile erläutert. Figur 9 zeigt die Schwellenverstärkung als Funktion der Wellenlänge. In Figur 9a und 9c geben die unausgefüllten Kreise die Schwellenverstärkungen und die spektralen Positionen der einzelnen Moden wieder, wenn das Laserbauelement im gesamten Resonatorbereich homogen gepumpt wird. Die axiale Variation der Gitterperiode wurde in diesem Beispiel so gewählt, daß die Schwellenverstärkungen von sechs spektral benachbarten Moden den gleichen Wert aufweisen. Diese Moden sind im folgenden von links nach rechts durchnummeriert (j = 1, 2, 3, 4, 5, m = 6). Die gestrichelte Linie dient zur Führung des Auges. Um eine bestimmte Mode unter den äquivalenten Moden bevorzugt anzusprechen, wird eine dafür geeignete inhomogene Strominjektion verwendet, d. h. für den Steuerstrom jeder einzelnen Sektion eine spezielle Stromstärke gewählt. In Figur 9a ist durch die ausgefüllten Kreise schematisch eine derartige, spezielle Situation inhomogener Strominjektion dargestellt, welche eine minimale Schwellenverstärkung für die Mode j=5 ermöglicht und diese dadurch gezielt anspricht. Die anderen Moden, welche unter homogener Strominjektion der Mode j = 5 äquivalent waren, werden durch diese spezielle inhomogene Strominjektion in ihrer Schwellenverstärkung angehoben. Die ausgefüllten Kreise geben die Schwellenverstärkungen und spektralen Positionen der einzelnen Moden an, wenn das Bauelement im gesamten Resonatorbereich gezielt inhomogen gepumpt wird, wobei die durchgezogene Linie wieder nur zur Führung des Auges dient. Um die selektierte Mode j = 5 durchzustimmen, werden eine oder zwei Injektions-Ströme in einer geeigneten Weise variiert, wodurch sich eine Wellenlängenänderung (Abstimmung) von 1 bis 2 nm ergibt, welche in Figur 9b durch den horizontal liegenden, dicken Doppelpfeil dargestellt ist. Bei der Wellenlängen-Abstimmung verschiebt sich in erster Linie das gesamte Profil, wie in Figur 9b durch die zwei gestrichelt dargestellten Profile gezeigt ist. Eine geringe Deformation des Profils tritt dabei erst in zweiter Linie auf. Um eine andere Mode auszuwählen und durchzustimmen, muß eine andere Kombination der Injektions-Ströme, d. h. ein anderes inhomogenes Strominjektions-Profil, angewendet werden. Eine derartige Situation ist für die Selektion der Mode j = 2 in Figur 9c durch die ausgefüllten Kreise dargestellt. Um die Mode j = 2 durchzustimmen, werden wieder ein oder zwei Injektions-Ströme geeignet variiert, wie schematisch durch den horizontal liegenden Doppelpfeil angedeutet ist. Zu jeder der sechs äquivalenten Moden korrespondiert ein horizontaler Doppelpfeil, welcher die Wellenlängen-Abstimmung dieser Mode andeutet. Dadurch ist der gesamte Wellenlängen-Durchstimmungsbereich des Mehrsektions-DFB-Lasers mit speziell gekrümmtem Lichtwellenleiter wesentlich größer, als der des Mehrsektions-DFB-Lasers mit geradem Lichtwellenleiter, wie durch die vertikalen, gestrichelten Linien angedeutet ist. Dieses Wellenlängen-Durchstimmungskonzept vereinigt quasi die Durchstimmungsbereiche mehrerer Mehrsektions-DFB-Laser mit spektral dicht benachbarten Wellenlängen der Bragg-Moden.

Dieses am Beispiel eines Bauelements einer Zeile demonstrierte Wellenlängen-Durchstimmungsprinzip wird im übertragenen Sinne auch auf die restlichen Bauelemente der Zeile angewendet.
Durch die Verwendung gekrümmter Lichtwellenleiter zur Erzeugung der speziellen axialen Variation der Gitterperiode treten jedoch keine Zusatzkosten bei der technologischen Herstellung dieser durchstimmbaren Bauelementezeile auf.

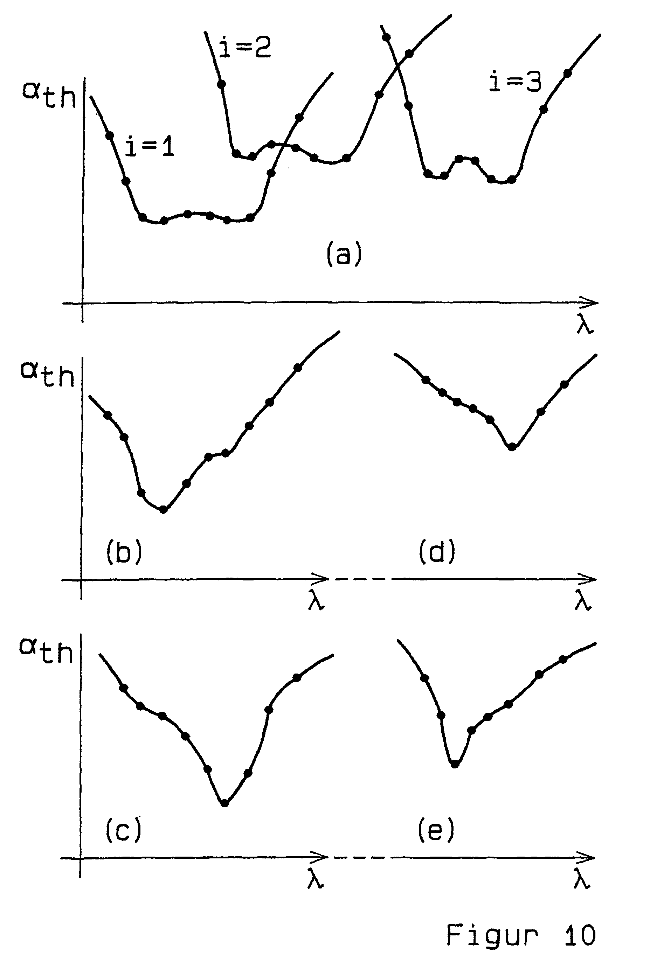

Figur 10 zeigt die Schwellenverstärkung als Funktion der Wellenlänge für eine andere Bauelementezeile mit drei unterschiedlich gekrümmten Lichtwellenleitern (i = 1, 2, 3). In diesem Fall sind die Krümmungsfunktionen so gewählt, daß bei axial homogener Strominjektion pro Lichtwellenleiter i sechs spektral benachbarte Moden existieren, welche eine ähnlich geringe Schwellenverstärkung aufweisen. Die Wellenlängenbereiche Δλ₁, Δλ₂ und Δλ₃ sind in ihren absoluten spektralen Lagen mit Hilfe der geometrischen Parameter der Krümmungsfunktionen so positioniert worden, daß sie sich spektral überlappen, wie im Fall i=1 und i=2, oder sich nicht überlappen, wie im Fall i=2 und i=3. Im oberen Bildteil ist jeweils der Fall dargestellt, daß in jeden Lichtwellenleiter die Strominjektion in axialer Richtung homogen erfolgt. Durch inhomogene Strominjektion (ermöglicht durch eine Multisektionierung der Lichtwellenleiter) können aus den sechs Moden jeweils einzelne Moden selektiert und in der Wellenlänge abgestimmt werden. Für die Lichtwellenleiter i = 1 wird im Fall (b) die Mode j₁ = 2 selektiert, im Fall (c) die Mode j₁ = 5. Für den Lichtwellenleiter i = 3 wird im Fall (d) die Mode j₃ = 6 selektiert, im Fall (e) die Mode j₃ = 3.

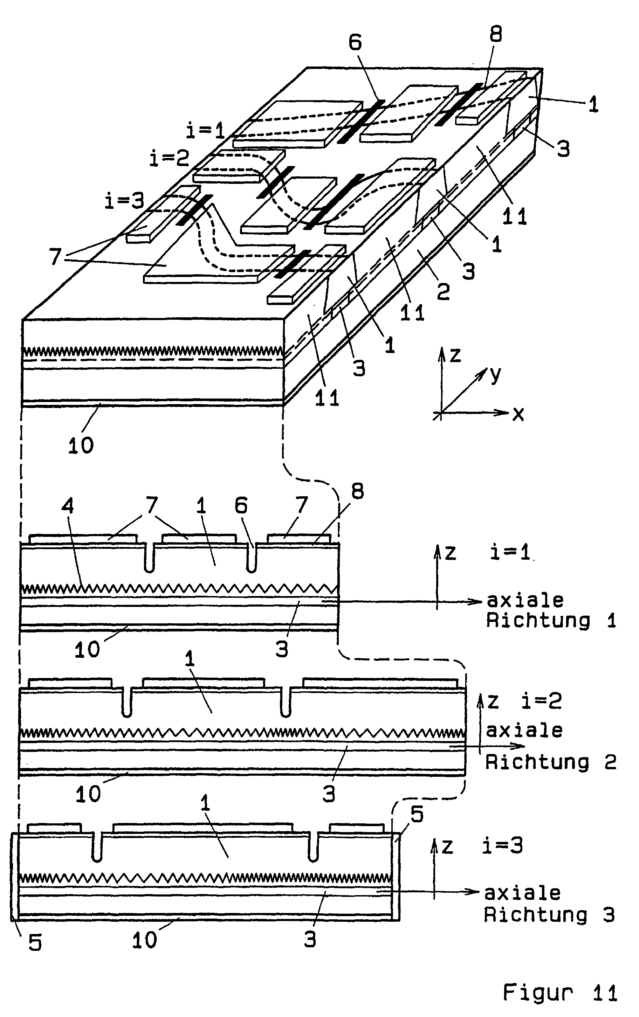

Figur 11 zeigt eine Ausführungsform mit 3 Wellenleitern, wobei jedem Wellenleiter 2 Unterteilungen zugeordnet sind, so daß drei 3-Sektions-Bauelemente existieren. Dieses Beispiel ist an das in Figur 1 dargestellte Beispiel angelehnt, zeigt jedoch bezüglich der aktiven Schichten 3, sowie bezüglich der Kontaktierung auf der Seite der Volumenhalbleiterschicht 1 vom Leitfähigkeitstyp I mögliche Ausgestaltungen. Das optische und elektronische Confinement wird in diesem Beispiel für jeden der 3 Wellenleiter mit einer sogenannten Pilzstruktur realisiert. Im oberen Bildteil sind an der rechten Grenzfläche drei Pilzstrukturen im Querschnitt dargestellt. Das Material 11 ist semiisolierend. Die Strominjektion in die gekrümmt verlaufenden aktiven Schichten wird in diesem Beispiel über die entsprechend gekrümmten Kontaktierungsstreifen 8 realisiert. Ladungsträger vom Leitfähigkeitstyp I fließen in diesem Beispiel von einem Kontaktierungsfeld 7 über den Kontaktierungsstreifen 8 in die Volumenhalbleiterschicht 1. Von dort werden diese Ladungsträger in die aktive Schicht 3 injiziert.

Im folgenden sei ein erstes Zahlenbeispiel angeführt, bei dem die Wellenlängenbereiche Δλ₁, Δλ₂, Δλ₃ und Δλ₄ in ihren absoluten spektralen Lagen aneinander anschließen. In diesem Fall ist im folgenden das Ungefährzeichen fast ein Gleichheitszeichen: α_{li,1} < α_{re,1}; α_{re,1} ∼ α_{li,2}; α_{li,2} < α_{re,2}; α_{re,2} ∼ α_{li,3}; α_{li,3} < α_{re,3}; α_{re,3} ∼ α_{li,4} und α_{li,4} < α_{re,4}. Ferner zeigen alle Lichtwellenleiter der Bauelementezeile eine Krümmung, bei der ∂²y/∂x² < 0 ist (siehe z. B. Figur 6). Der effektive Brechungsindex ist in diesem Fall N_{eff} = 3.22785 und für dieses Beispiel aus Gründen der Einfachheit wellenlängenunabhängig angenommen. Ferner sei der Kippwinkel des Rückkopplungsgitters ϕ = 10° und die Gitterperiode im homogenen Rückkopplungsgitter Λₒ = 237 nm. Die Wellenlängen λ_{min,i} = 2N_{eff}Λₒ/cosϑ_{min,i} und λ_{max,i} = 2_{Neff}Λₒ/cosϑ_{max,i} spannen dabei den Wellenlängenbereich Δλᵢ = λ_{max,i} - λ_{min,i} auf. ϑ_{min,i} ist in diesem Beispiel der lokale Kippwinkel des Lichtwellenleiters bezogen auf das Rückkopplungsgitter 4 an der Stelle x = 0. ϑ_{max,i} ist in diesem Beispiel der lokale Kippwinkel des Lichtwellenleiters bezogen auf das Rückkopplungsgitter 4 an der Stelle x = L.

Tabelle 1 zeigt auf dieser Grundlage ein Ausführungsbeispiel für eine Laserzeile mit 4 Kanälen

**Tabelle: 1**

| **i** | **α**_{**li**} | **ϑ**_{**min**} | **λ**_{**min**} **(ϑ**_{**min**}**)** | **∝**_{**re**} | **ϑ**_{**max**} | **λ**_{**max**}**(ϑ**_{**max**}**)** |
|---|---|---|---|---|---|---|
| 1 | -10° | 0 | 1,53µm | -4,34° | 5,66° | 1,5375µm |
| 2 | -4,34° | 5,66° | 1,5375µm | -2,01° | 7,99° | 1,45µm |
| 3 | -2,01° | 7,99° | 1,545µm | -0,23° | 9,77° | 1,525µm |
| 4 | -0,23° | 9,77° | 1,5525µm | +1,25° | 11, 25° | 1,6µm |

Dadurch ergibt sich, daß die Bauelementezeile mit vier Mehrsektionslasern den Bereich von 1.53µm bis 1.56 µm durch Wellenlängen-Abstimmung aller vier Laser lückenlos abdecken kann. Dieses Beispiel kann noch folgendermaßen verallgemeinert werden:
1.) Wellenlängenüberlapp der Wellenlängenbereiche der einzelnen Kanäle (z. B. Fig. 8).
2.) Kein Wellenlängenüberlapp der Wellenlängenbereiche der einzelnen Kanäle.
3.) Alle Wellenlängenbereiche Δλᵢ sind verschieden und nicht wie in diesem Beispiel gleich 7.5 nm.

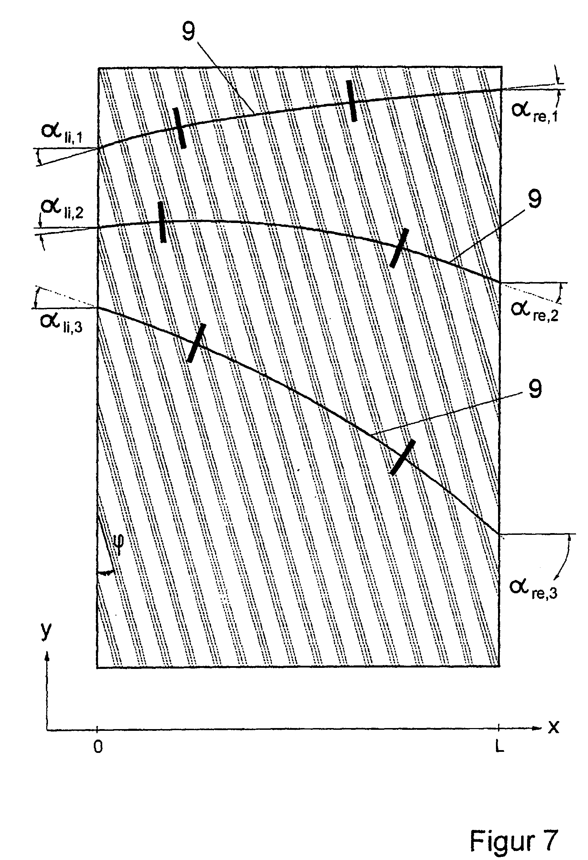

Als nächstes sei ein zweites Zahlenbeispiel angeführt, welches zu einer weiteren Bauelementezeile mit vier verschieden gekrümmten Lichtwellenleitern korrespondiert. Bei diesem Beispiel schließen sich die Wellenlängenbereiche Δλ₁, Δλ₂, Δλ₃ und Δλ₄ in ihren absoluten spektralen Lagen nicht lückenlos aneinander an. Alle Lichtwellenleiter besitzen in den Wellenleiter-Krümmungsfunktionen keinen Wendepunkt. Sie sind alle in einer Weise gekrümmt, welche in Figur 7 qualitativ dargestellt ist (Krümmung δ²y/δx² < 0).
α_{li,1} = -4°; α_{re,1} = -3,2°; α_{li,2} = -2,5°; α_{re,2} = -1,1°;
α_{li,3} = -0,2°; α_{re,3} = +0,8°; α_{li,4} = 1,3° und α_{re,4} = 2,9°.

Als nächstes wird ein drittes Zahlenbeispiel beschrieben, welches zu einer weiteren Bauelementezeile mit fünf verschieden gekrümmten Lichtwellenleitern korrespondiert. Bei diesem Beispiel überlappen die Wellenlängenbereiche Δλ₁, Δλ₂, Δλ₃, Δλ₄ und Δλ₅ in ihren absoluten spektralen Lagen in einigen Fällen, in anderen Fällen dagegen nicht. Alle Lichtwellenleiter weisen keinen Wendepunkt in den Wellenleiterkrümmungen auf. Sie sind alle in einer Weise gekrümmt, welche in Figur 7 qualitativ dargestellt ist (Krümmung δ²y/δx² < 0). α_{li,1} = -5°; α_{re,1} = -4,°;
α_{li,2} = -3,3°; α_{re,2} = -1,4°; α_{li,3} = -2,2°; α_{re,3} = -0,8°;
α_{li,4} = 0,1°; α_{re,4} = 4,9°; α_{li,5} = 1,3° und α_{re,5} = 4,4°.

Die Erfindung kann in photonischen Komponenten Anwendung finden, welche auf verschiedenen Wellenleiter-Kanälen arbeiten und welche auf DFB (engl. = distributed feedback) Gittern, DBR (engl. = distributed Bragg reflector) Gittern oder axial mehrfach unterbrochenen Gitterstrukturen (engl.: "sampled gratings") basieren. Im letzten Fall besteht der Gitterbereich abwechselnd aus Gitterfeldern und gitterfreien Bereichen, wobei die entsprechenden Längen in axialer Richtung zusätzlich noch variierbar sind. Das Prinzip ist unabhängig von speziellen Bauformen auf verschiedene photonische Bauelemente anwendbar, wenn diese auf optischen Rückkopplungsgittern basieren.

### Aufstellung der verwendeten Bezugszeichen

- 1: Volumenhalbleiterschicht vom Leitfähigkeitstyp I
- 2: Volumenhalbleiterschicht vom Leitfähigkeitstyp II
- 3: aktive Schicht
- 4: Rückkopplungsgitter
- 5: Facettenvergütung
- 6: Trennungsgraben (Kontakt-Trennung)
- 7: Metallisierungsfelder (contact pads) der einzelnen Sektionen auf der Seite des Leitfähigkeitstyps I
- 8: Metallisierungsstreifen, welche den Wellenleiterkrümmungen folgen, auf der Seite der Volumenhalbleiterschicht 1 vom Leitfähigkeitstyp I
- 9: Projektion des Wellenleiterzentrums (= axiale Richtung) auf die Bauelemente-Oberfläche (parallel zur xy-Ebene)
- 10: Metallisierung auf der Seite des Leitfähigkeitstyps II
- 11: semiisolierendes Material
- ϕ: Kippwinkel des Rückkopplungsgitters
- i: Ordnungszahl des Lichtwellenleiters
- ϑ: lokaler Kippwinkel des Lichtwellenleiters
- Λ₀: Gitterperiode im homogenen Teil des Rückkopplungsgitters
- yᵢ(x): Krümmungsfunktion des Wellenleiters der Ordnungszahl i
- αₜₕ: Schwellenverstärkung
- Δλ,: Wellenlängenbereich (Wellenlängenintervall)
- L: Länge des Gitterfeldes in x - Richtung
- jᵢ: Kennziffer der Moden des Wellenleiters der Ordnungszahl i
- δ²y/δx²: Stärke und Richtung der Krümmungsfunktion des Wellenleiters
- N_{eff}: effektiver Brechungsindex des Lichtwellenleiters
- α_{li,i}: Winkel zwischen dem Wellenleiter der Ordnungszahl i und der x - Richtung an der Stelle x = 0 (linke Grenzfläche)
- α_{re,i}: Winkel zwischen dem Wellenleiter der Ordnungszahl i und der x - Richtung an der Stelle x = L (rechte Grenzfläche)

- I₀(x): Maximalbetrag der Intensität des im Wellenleiter geführten Lichtfeldes an der Stelle x
- K: Kopplungskoeffizient
- λᵢ: Emissionswellenlänge des Wellenleiters der Ordnungszahl i
- Index re: Bezug auf rechte Grenzfläche
- Index li: Bezug auf linke Grenzfläche
- λ_{min,i}: Wellenlänge der Mode mit der geringsten Wellenlänge unter den Moden mit der niedrigsten Schwellenverstärkung des Wellenleiters mit der Ordnungszahl i
- λ_{max,i}: Wellenlänge der Mode mit der größten Wellenlänge unter den Moden mit der niedrigsten Schwellenverstärkung des Wellenleiters mit der Ordnungszahl i
- Δλᵢ: Wellenlängenbereich, über den sich die mᵢ Moden erstrecken

## Patentansprüche

1. Wellenlängenabstimmbares optoelektronisches Bauelement, das aus einer Volumenhalbleiterschicht (2) vom Leitfähigkeitsyp II, mindestens einer aktiven Schicht (3), n individuell in der x-y-Ebene gekrümmten Lichtwellenleitern, mindestens einem Rückkopplungsgitter (4), einer Volumenhalbleiterschicht (1) vom Leitfähigkeitstyp I und einer Kontaktierungsanordnung besteht, daß der gesamte Gitterbereich des Rückkopplungsgitters (4) in axialer x-Richtung die Länge L aufweist, daß zwei Grenzflächen senkrecht zur x-Achse stehen, wobei die linke Grenzfläche am linken Ende des Gitterbereiches bei x = 0 und die rechte Grenzfläche am rechten Ende des Gitterbereiches bei x = L liegt, daß die jedem Lichtwellenleiter zugeordnete Kontaktierungsanordnung auf der Seite der Volumenhalbleiterschicht (1) vom Leitfähigkeitstyp I in axialer x-Richtung unterbrochen und auf der Seite der Volumenhalbleiterschicht (2) vom Leitfähigkeitstyp II in axialer Richtung ununterbrochen verläuft, daß in die aktive/n Schicht/en (3) des Lichtwellenleiters Ladungsträger vom Leitfähigkeitstyp I und II injiziert sind, und daß über mindestens einem der Lichtwellenleiter, mindestens ein Trennungsgraben (6), angeordnet ist, daß Tiefe, Breite, laterale Position und Material des Trennungsgrabens (6) zwischen den durch den Trennungsgraben (6) begrenzten, einzeln kontaktierbaren Sektionen über einem gekrümmten Lichtwellenleiter derart dimensioniert sind, daß zwischen jeweils zwei durch den Trennungsgraben (6) begrenzten Sektionen, immer ein ohmscher Widerstand von mindestens 10 Ohm besteht, so daß jeder über dem Lichtwellenleiter der Ordnungszahl i liegenden Sektion über ihr Metallisierungsfeld (7) ein individuell einstellbarer Strom zugeführt werden kann, und daß die Krümmungsfunktion yᵢ(x) des Lichtwellenleiters der Ordnungszahl i durch die folgenden Bedingungen festgelegt ist, die ein identisches Potential der Metallisierungsfelder (7) voraussetzen,
- daß mindestens drei spektral benachbarte Moden der Kennziffer jᵢ vorhanden sind, welche von allen Moden des Lichtwellenleiters der Ordnungszahl i die geringsten Schwellenverstärkungen aufweisen,
- daß die Schwellenverstärkungen α_{th,jᵢ,i} der spektral benachbarten Moden sich voneinander höchstens um 4% ihrer Absolutwerte unterscheiden, wobei jᵢ = 1, 2,...mᵢ ist, wobei jede der spektral benachbarten Moden in ihrer Schwellenverstärkung zu den übrigen Moden des Lichtwellenleiters der Ordnungszahl i einen Unterschied von mindestens 8% aufweist,
- daß das Spektrum des Wellenleiters der Ordnungszahl i mit der Krümmungsfunktion yᵢ(x) genau jᵢ spektral benachbarte Moden aufweist, die sich über den Wellenlängenbereich Δλᵢ = λ_{max,i} - λ_{min,i} erstrecken, wobei i ganzzahlig im Bereich 1 ≤ i ≤ n ist,
**dadurch gekennzeichnet,**
**daß** der Gesamtwellenlängenbereich, in dem das Bauelement arbeitet, aus den Wellenlängenbereichen Δλᵢ der individuellen Wellenleiter zusammengesetzt ist, wobei i ganzzahlig im Bereich 1≤ i ≤ n ist, und daß die Wellenlängenbereiche der n verschiedenen Lichtwellenleiter spektral durch die Beziehung |λ_{max,k} - λ_{min,k+1}| < (Δλₖ + Δλₖ₊₁)/10 zu beschreiben sind, wobei k ganzzahlig 1 ≤ k ≤ (n-1) ist.

2. Wellenlängenabstimmbares optoelektronisches Bauelement nach Anspruch 1 **dadurch gekennzeichnet, daß** die zur x -Achse senkrecht stehenden Grenzflächen mit den Bauelementegrenzen in x - Richtung zusammenfallen, wobei L die Bauelementelänge in x - Richtung darstellt.

3. Wellenlängenabstimmbares optoelektronisches Bauelement nach Anspruch 1 **dadurch gekennzeichnet, daß** mindestens ein optischer Lichtwellenleiter an mindestens einer Gittergrenze die Grenzfläche durchbricht und in einen Bereich außerhalb des Gitterbereiches x < 0 an der linken Grenzfläche und außerhalb des Gitterbereiches x > L an der rechten Grenzfläche fortgesetzt ist.

4. Wellenlängenabstimmbares optoelektronisches Bauelement nach Anspruch 1 **dadurch gekennzeichnet, daß** der Gitterbereich ein Ausschnitt einer integrierten optoelektronischen Schaltung ist.

5. Wellenlängenabstimmbares optoelektronisches Bauelement nach Anspruch 1 **dadurch gekennzeichnet, daß** sich die Wellenlängenbereiche Δλ₁, ..., Δλₙ spektral überlappen.

6. Wellenlängenabstimmbares optoelektronisches Bauelement nach Anspruch 1 **dadurch gekennzeichnet, daß** sich die Wellenlängenbereiche Δλ₁, ..., Δλₙ spektral nicht überlappen.

7. Wellenlängenabstimmbares optoelektronisches Bauelement nach Anspruch 1 **dadurch gekennzeichnet, daß** sich die Wellenlängenbereiche ausgewählter Lichtwellenleiter spektral überlappen.

8. Wellenlängenabstimmbares optoelektronisches Bauelement nach Anspruch 1 **dadurch gekennzeichnet, daß** der Winkel α_{li,i} zwischen dem Lichtwellenleiter der Ordnungszahl i und der x- Richtung an der Stelle x = 0, das heißt an der linken Grenzfläche, sowie der Winkel α_{re,i} zwischen dem Lichtwellenleiter der Ordnungszahl i und der x- Richtung an der Stelle x = L, daß heißt an der rechten Grenzfläche, mit den entsprechenden Winkeln der übrigen Lichtwellenleiter in einer charakteristischen Relation steht, wobei gilt
α_{li,1} < α_{re,1}; |α_{re,1} - α_{li,2}| < 0,2°;
α_{li,2} < α_{re,2}; |α_{re,2} - α_{li,3}| < 0,2°;..;
α_{li,n-1} < α_{re,n-1} ; |α_{re,n-1} - α_{1i,n}| < 0,2°;
α_{1i,n} < α_{re,n}.

9. Wellenlängenabstimmbares optoelektronisches Bauelement nach Anspruch 1 **dadurch gekennzeichnet, daß** der Winkel α_{1i,i} zwischen dem Lichtwellenleiter der Ordnungszahl i und der x- Richtung an der Stelle x = 0, das heißt an der linken Grenzfläche, sowie der Winkel α_{re,i} zwischen dem Lichtwellenleiter der Ordnungszahl i und der x- Richtung an der Stelle x = L, das heißt an der rechten Grenzfläche, mit den entsprechenden Winkeln der übrigen Lichtwellenleiter in einer charakteristischen Relation steht, wobei gilt
α_{li,1} > α_{re,1}; |α_{re,1} - α_{li,2}| < 0,2°;
α_{li,2} > α_{re,2}; |α_{re,2} - α_{li,3}| < 0,2°; ..;.
α_{li,n-1} > α_{re,n-1}; |α_{re,n-1} - α_{li,n}| < 0-2°;
α_{li,n} > α_{re,n}.

10. Wellenlängenabstimmbares optoelektronisches Bauelement nach Anspruch 1 **dadurch gekennzeichnet, daß** die Volumenhalbleiterschicht (1) vom Leitfähigkeitstyp I eine n-Leitung und die Volumenhalbleiterschicht (2) vom Leitfähigkeitstyp II eine p-Leitung aufweist.

11. Wellenlängenabstimmbares optoelektronisches Bauelement nach Anspruch 1 **dadurch gekennzeichnet, daß** die Volumenhalbleiterschicht (1) vom Leitfähigkeitstyp I eine p-Leitung und die Volumenhalbleiterschicht (2) vom Leitfähigkeitstyp II eine n-Leitung aufweist.

12. Wellenlängenabstimmbares optoelektronisches Bauelement nach Anspruch 1 **dadurch gekennzeichnet, daß** die Kopplung des Rückkopplungsgitters (4) komplex ist und Index- sowie Gewinnkopplung beinhaltet.

13. Wellenlängenabstimmbares optoelektronisches Bauelement nach Anspruch 1 **dadurch gekennzeichnet, daß** die Kopplung des Rückkopplungsgitters (4) komplex ist und Index- sowie Verlustkopplung beinhaltet.

14. Wellenlängenabstimmbares optoelektronisches Bauelement nach Anspruch 1 **dadurch gekennzeichnet, daß** die Kopplung des Rückkopplungsgitters (4) rein imaginär ist und Verlustkopplung beinhaltet.

15. Wellenlängenabstimmbares optoelektronisches Bauelement nach Anspruch 1 **dadurch gekennzeichnet, daß** die Kopplung des Rüpckkopplungsgitters (4) rein imaginär ist und Gewinnkopplung beinhaltet.

16. Wellenlängenabstimmbares optoelektronisches Bauelement nach Anspruch 1 **dadurch gekennzeichnet, daß** die Kopplung des Rückkopplungsgitters (4) reell ist und reine Indexkopplung beinhaltet.

17. Wellenlängenabstimmbares optoelektronisches Bauelement nach Anspruch 1 **dadurch gekennzeichnet, daß** beliebig gekrümmt verlaufende, sich jedoch nicht überkreuzende Lichtwellenleiter eingesetzt werden.

18. Wellenlängenabstimmbares optoelektronisches Bauelement nach Anspruch 1 **dadurch gekennzeichnet, daß** mindestens einer der Lichtwellenleiter ungekrümmt ist.

19. Wellenlängenabstimmbares optoelektronisches Bauelement nach Anspruch 1 **dadurch gekennzeichnet, daß** die Winkel ϕ,ϑ, α_{re,i} und α_{li,i} kleiner als 20° sind.

20. Wellenlängenabstimmbares optoelektronisches Bauelement nach Anspruch 1 **dadurch gekennzeichnet, daß** das Rückkopplungsgitter (4) u. a. in einem Bereich liegt, in dem die Intensität des im Lichtwellenleiter geführten Lichtfeldes einen Betrag aufweist, der größer als I₀/100 ist, wobei I₀ die Intensität im Maximum des Lichtfeldes ist, und daß für die dadurch erreichte Rückkopplung mit dem Kopplungskoeffizienten (K) und der Länge des Gitterfeldes in x - Richtung (L) die Relation 0,2 ≤ K · L ≤ 7 gilt.

## Claims

1. Wavelength-tunable optoelectronic component consisting of a bulk semiconductor layer (2) of conductivity type II, at least one active layer (3), n waveguides individually curved in the x-y plane, at least one feedback grating (4), a bulk semiconductor layer (1) of conductivity type I and a bonding arrangement, wherein the entire grating area of the feedback grating (4) is of length L in the axial x-direction, wherein two boundary surfaces are perpendicular to the x-axis, the left-hand boundary surface being at the left-hand end of the grating area at x = 0 and the right-hand boundary surface being at the right-hand end of the grating area at x = L, wherein the bonding arrangement associated with each waveguide extends discontinuously in the axial x-direction on the side of the bulk semiconductor layer (1) of conductivity type I and extends continuously in the axial direction on the side of the bulk semiconductor layer (2) of conductivity type II, wherein charge carriers of conductivity types I and II are injected into the active layer(s) (3) of the waveguide, and wherein at least one isolation trench (6) is disposed over at least one of the waveguides, wherein the depth, width, lateral position and material of the isolation trench (6) between the individually bondable sections over a curved waveguide - said sections being bounded by the isolation trench (6) - are dimensioned such that there is always an ohmic resistance of at least 10 ohms between every two sections bounded by the isolation trench (6), with the result that each section over the waveguide of ordinal number i can be supplied via its contact pad (7) with an individually adjustable current, wherein the curvature function yᵢ(x) of the waveguide of ordinal number i is defined by the following conditions, which assume an identical potential of the contact pads (7),
- there are at least three spectrally adjacent modes of index jᵢ which, of all the modes of the waveguide of ordinal number i, have the lowest threshold amplifications;
- the threshold amplifications α_{th,ji,i} of the spectrally adjacent modes differ from each other by no more than 4% of their absolute values, where jᵢ = 1, 2,...mᵢ, each of the spectrally adjacent modes differing in its threshold amplification from the other modes of the waveguide of ordinal number i by at least 8%;
- the spectrum of the waveguide of ordinal number i with curvature function yᵢ(x) comprises exactly jᵢ spectrally adjacent modes extending over the wavelength range Δλᵢ = λ_{max,i} - λ_{min,i}, where i is an integer in the range 1 ≤ i ≤ n;
**characterized in that**
the total wavelength range in which the component operates is composed of the wavelength ranges Δλᵢ of the individual waveguides, where i is an integer in the range 1 ≤ i ≤ n, and the wavelength ranges of the n different waveguides can be described spectrally by the relationship |λ_{max,k} - λ_{min,k+1}| < (Δλₖ + Δλₖ₊₁)/10, where k is an integer 1 ≤ k ≤ (n-1).

2. Wavelength-tunable optoelectronic component according to claim 1, **characterized in that** the boundary surfaces perpendicular to the x-axis coincide with the component boundaries in the x-direction, L representing the component length in the x-direction.

3. Wavelength-tunable optoelectronic component according to claim 1, **characterized in that** at least one optical waveguide penetrates the boundary surface at at least one grating boundary and is continued into an area outside the grating area x < 0 at the left-hand boundary surface and outside the grating area x > L at the right-hand boundary surface.

4. Wavelength-tunable optoelectronic component according to claim 1, **characterized in that** the grating area is a section of an integrated optoelectronic circuit.

5. Wavelength-tunable optoelectronic component according to claim 1, **characterized in that** the wavelength ranges Δλ₁, ..., Δλₙ spectrally overlap.

6. Wavelength-tunable optoelectronic component according to claim 1, **characterized in that** the wavelength ranges Δλ₁, ..., Δλₙ do not spectrally overlap.

7. Wavelength-tunable optoelectronic component according to claim 1, **characterized in that** the wavelength ranges of selected waveguides spectrally overlap.

8. Wavelength-tunable optoelectronic component according to claim 1, **characterized in that** the angle α_{1i,i} between the waveguide of ordinal number i and the x-direction at the position x = 0, i.e. at the left-hand boundary surface, and the angle α_{re,i} between the waveguide of ordinal number i and the x-direction at the position x = L, i.e. at the right-hand boundary surface, have a characteristic relation with the corresponding angles of the other waveguides, there applying the following:
α_{li,1} < α_{re,1}; |α_{re,1} - α_{li,2}| < 0,2°;
α_{li,2} < α_{re,2}; |α_{re,2} - α_{li,3}| < 0,2°;..;
α_{li,n-1} < α_{re,n-1} ; |α_{re,n-1} - α_{1i,n}| < 0,2°;
α_{1i,n} < α_{re,n}.

9. Wavelength-tunable optoelectronic component according to claim 1, **characterized in that** the angle α_{1i,i} between the waveguide of ordinal number i and the x-direction at the position x = 0, i.e. at the left-hand boundary surface, and the angle α_{re,i} between the waveguide of ordinal number i and the x-direction at the position x = L, i.e. at the right-hand boundary surface, have a characteristic relation with the corresponding angles of the other waveguides, there applying the following:
α_{li,1} > α_{re,1}; |α_{re,1} - α_{li,2}| < 0,2°;
α_{li,2} > α_{re,2}; |α_{re,2} - α_{li,3}| < 0,2°; ..;.
α_{li,n-1} > α_{re,n-1}; |α_{re,n-1} - α_{li,n}| < 0-2°;
α_{li,n} > α_{re,n}.

10. Wavelength-tunable optoelectronic component according to claim 1, **characterized in that** the bulk semiconductor layer (1) of conductivity type I has an n-conductor and the bulk semiconductor layer (2) of conductivity type II has a p-conductor.

11. Wavelength-tunable optoelectronic component according to claim 1, **characterized in that** the bulk semiconductor layer (1) of conductivity type I has a p-conductor and the bulk semiconductor layer (2) of conductivity type II has an n-conductor.

12. Wavelength-tunable optoelectronic component according to claim 1, **characterized in that** the coupling of the feedback grating (4) is complex and contains index as well as gain coupling.

13. Wavelength-tunable optoelectronic component according to claim 1, **characterized in that** the coupling of the feedback grating (4) is complex and contains index as well as loss coupling.

14. Wavelength-tunable optoelectronic component according to claim 1, **characterized in that** the coupling of the feedback grating (4) is exclusively imaginary and contains loss coupling.

15. Wavelength-tunable optoelectronic component according to claim 1, **characterized in that** the coupling of the feedback grating (4) is exclusively imaginary and contains gain coupling.

16. Wavelength-tunable optoelectronic component according to claim 1, **characterized in that** the coupling of the feedback grating (4) is real and contains exclusively index coupling.

17. Wavelength-tunable optoelectronic component according to claim 1, **characterized in that** use is made of waveguides of any curvature which, however, do not cross.

18. Wavelength-tunable optoelectronic component according to claim 1, **characterized in that** at least one of the waveguides is uncurved.

19. Wavelength-tunable optoelectronic component according to claim 1, **characterized in that** the angles ϕ, ϑ, α_{re,i} and α_{li,i} are smaller than 20°.

20. Wavelength-tunable optoelectronic component according to claim 1, **characterized in that** the feedback grating (4) is, inter alia, in an area in which the intensity of the light field conducted in the waveguide is of a value greater than I₀/100, where I₀ is the intensity at the maximum of the light field, wherein, for the thereby achieved feedback with the coupling coefficient (K) and the length of the grating field in the x-direction (L), there applies the relation 0.2 ≤ K · L ≤ 7.

## Revendications

1. Composant optoélectronique ajustable à la longueur d'onde, composé d'une couche de semi-conducteur à effet de volume (2) de type de conductivité II, d'au moins une couche active (3), de n guides d'ondes lumineuses courbés individuellement dans le plan xy, d'au moins une grille de rétroaction (4), d'une couche de semi-conducteur à effet de volume (1) de type de conductivité I et d'un montage de contacts, tel que l'ensemble de la grille de rétroaction (4) a dans le sens axial x la longueur L, que deux surfaces de séparation sont perpendiculaires à l'axe x, la surface de séparation de gauche à l'extrémité gauche de la grille se trouvant à x = 0 et la surface de séparation de droite à l'extrémité droite de la grille se trouvant à x = L, que le montage de contacts correspondant à chaque guide d'ondes lumineuses est interrompu du côté de la couche de semi-conducteur à effet de volume (1) de type de conductivité I dans le sens axial x et reste ininterrompu au niveau de la couche de semi-conducteur à effet de volume (2) de type de conductivité II dans le sens axial, que des porteurs de charge des types de conductivité I et II sont injectés dans la/les couche(s) active(s) (3) du guide d'ondes lumineuses, au moins un fossé de séparation (6) étant ménagé sur au moins l'un des guides d'ondes lumineuses, que la profondeur, la largeur, la position latérale et le matériau du fossé de séparation (6) entre les sections contactables individuellement sont dimensionnés par le biais d'un guide d'ondes courbé de telle façon qu'entre deux sections délimitées par le fossé de séparation (6), il existe toujours une résistance ohmique d'au moins 10 Ohm, de sorte qu'un courant réglable individuellement peut être amené à chaque section se trouvant sur le guide d'ondes numéroté i par le biais du champs de métallisation (7) de ladite section, la fonction de courbure yᵢ(x) du guide d'ondes numéroté i étant déterminée par les conditions suivantes, qui supposent un potentiel identique des champs de métallisation (7) :
- il doit exister au moins trois modes spectralement adjacents de l'indice jᵢ, lesquels, parmi tous les modes du guide d'ondes lumineuses numéroté i, accusent les plus bas seuils d'amplification ;
- les seuils d'amplification •ₜₕ, jᵢ, i des modes spectralement adjacents doivent s'écarter les uns des autres au maximum de 4 % de leurs valeurs absolues, jᵢ étant égal à 1, 2, ... mᵢ et le seuil d'amplification de chacun des modes spectralement adjacents accusant une différence d'au moins 8 % par rapport aux autres modes du guide d'ondes numéroté i ;
- le spectre du guide d'ondes numéroté i de fonction de courbure yᵢ(x) doit présenter exactement jᵢ modes spectralement adjacents s'étendant sur la gamme de longueurs d'ondes ••ᵢ = •_{max,i} - •_{min.i}, i étant tel, en nombre entier, que 1 • i • n,
**caractérisé en ce que**
l'ensemble de la gamme de longueurs d'ondes dans laquelle le composant fonctionne se compose des gammes de longueurs d'ondes ••ᵢ des différents guides d'ondes, i étant tel, en nombre entier, que 1 • i • n, et **en ce que** les gammes de longueurs d'ondes des n guides d'ondes différents peuvent répondre spectralement à la relation
|•_{max,k} - •_{min,k+1|} < (••ₖ+••ₖ₊₁)/10,
k étant tel, en nombre entier, que 1 • k • (n-1).

2. Composant optoélectronique ajustable à la longueur d'onde selon la revendication 1, **caractérisé en ce que** les surfaces de séparation perpendiculaires à l'axe x correspondent aux limites des composants dans la direction x, L représentant la longueur du composant dans la direction x.

3. Composant optoélectronique ajustable à la longueur d'onde selon la revendication 1, **caractérisé en ce qu'**au moins un guide d'ondes optique franchit la surface de séparation à au moins une limite de grille et se poursuit dans une zone située en dehors de la section de grille x < 0 sur la surface de séparation gauche et en dehors de la section de grille x > L sur la surface de séparation droite.

4. Composant optoélectronique ajustable à la longueur d'onde selon la revendication 1, **caractérisé en ce que** la section de grille constitue une partie d'un circuit intégré optoélectronique.

5. Composant optoélectronique ajustable à la longueur d'onde selon la revendication 1, **caractérisé en ce que** les gammes de longueurs d'ondes ••₁, ..., ••ₙ se chevauchent spectralement.

6. Composant optoélectronique ajustable à la longueur d'onde selon la revendication 1, **caractérisé en ce que** les gammes de longueurs d'ondes ••₁, ..., ••ₙ ne se chevauchent pas spectralement.

7. Composant optoélectronique ajustable à la longueur d'onde selon la revendication 1, **caractérisé en ce que** les gammes de longueurs d'ondes de guides d'ondes sélectionnés se chevauchent spectralement.

8. Composant optoélectronique ajustable à la longueur d'onde selon la revendication 1, **caractérisé en ce que** l'angle •_{li,1} entre le guide d'ondes lumineuses numéroté i et la direction x au point x = 0, c'est-à-dire sur la surface de séparation gauche, ainsi que l'angle •_{re,1} entre le guide d'ondes lumineuses numéroté i et la direction x au point x = L, c'est-à-dire sur la surface de séparation droite, sont en relation caractéristique avec les angles correspondants des autres guides d'ondes, compte tenu que
•_{li,1} < •_{re,1} ; |•_{re,1} - •_{li,2}| < 0,2° ;
•_{li,2} < •_{re,2} ; |•_{re,2} - •_{li,3}| < 0,2° ; .. ;
•_{li,n-1} < •_{re,n-1} ; |•_{re,n-1} - •_{li,n}| < 0,2° ;
•_{li,n} < •_{re,n}.

9. Composant optoélectronique ajustable à la longueur d'onde selon la revendication 1, **caractérisé en ce que** l'angle •_{li,i} entre le guide d'ondes lumineuses numéroté i et la direction x au point x = 0, c'est-à-dire sur la surface de séparation gauche, ainsi que l'angle •_{re,i} entre le guide d'ondes lumineuses numéroté i et la direction x au point x = L, c'est-à-dire sur la surface de séparation droite, sont en relation caractéristique avec les angles correspondants des autres guides d'ondes, compte tenu que
•_{li,1} < •_{re,1} ; |•_{re,1} - •_{li,2}| < 0.2° ;
•_{li,2} < •_{re,2} ; |•_{re,2} - •_{li,3}| < 0,2° ;.. ;
•_{li,n-1} < •_{re,n-1} ; |•_{re,n-1} - •_{li,n}| < 0.2° ;
•_{li,n} < •_{re,n}.

10. Composant optoélectronique ajustable à la longueur d'onde selon la revendication 1, **caractérisé en ce que** la couche de semi-conducteur à effet de volume (1) de type de conductivité I présente un semi-conducteur de type n et la couche de semi-conducteur à effet de volume (2) de type de conductivité II présente un semi-conducteur de type p.

11. Composant optoélectronique ajustable à la longueur d'onde selon la revendication 1, **caractérisé en ce que** la couche de semi-conducteur à effet de volume (1) de type de conductivité I présente un semi-conducteur de type p et la couche de semi-conducteur à effet de volume (2) de type de conductivité II présente un semi-conducteur de type n.

12. Composant optoélectronique ajustable à la longueur d'onde selon la revendication 1, **caractérisé en ce que** le couplage de la grille de rétroaction (4) est complexe et comprend aussi bien un couplage d'indice qu'un couplage de gain.

13. Composant optoélectronique ajustable à la longueur d'onde selon la revendication 1, **caractérisé en ce que** le couplage de la grille de rétroaction (4) est complexe et comprend aussi bien un couplage d'indice qu'un couplage de perte.

14. Composant optoélectronique ajustable à la longueur d'onde selon la revendication 1, **caractérisé en ce que** le couplage de la grille de rétroaction (4) est purement imaginaire et comprend un couplage de perte.

15. Composant optoélectronique ajustable à la longueur d'onde selon la revendication 1, **caractérisé en ce que** le couplage de la grille de rétroaction (4) est purement imaginaire et comprend un couplage de gain.

16. Composant optoélectronique ajustable à la longueur d'onde selon la revendication 1, **caractérisé en ce que** le couplage de la grille de rétroaction (4) est réel et comprend uniquement un couplage d'indice.

17. Composant optoélectronique ajustable à la longueur d'onde selon la revendication 1, **caractérisé en ce que** sont utilisés des guides d'ondes lumineuses pouvant accuser des courbures quelconques, mais ne devant pas se croiser.

18. Composant optoélectronique ajustable à la longueur d'onde selon la revendication 1, **caractérisé en ce que** au moins un des guides d'ondes lumineuses n'est pas courbé.

19. Composant optoélectronique ajustable à la longueur d'onde selon la revendication 1, **caractérisé en ce que** les angles •, •, •_{re,i} et •_{li,i} sont inférieurs à 20°.

20. Composant optoélectronique ajustable à la longueur d'onde selon la revendication 1, **caractérisé en ce que** la grille de rétroaction (4) se trouve entre autres dans une zone dans laquelle l'intensité du champ lumineux conduit dans le guide d'ondes lumineuses a une valeur supérieure à Iₒ/100, Iₒ représentant l'intensité au maximum du champ lumineux et **en ce que** la relation 0,2 ≤ K · L ≤ 7 s'applique à la rétroaction ainsi obtenue avec un coefficient de couplage K et une longueur L du champ de la grille en direction x.
